# EUROPEAN PATENT APPLICATION

(11) **EP 1 206 039 A2**
(43) Date of publication of application: **15.05.2002**
(21) Application number: 01660202.1
(22) Date of filing: 05.11.2001
(51) Int. Cl.: H03L 7/23

(54) **A synthesizer arrangement and a method for generating signals, particularly for a multimode radio telephone device**

(30) Priority: 08.11.2000 FI 20002447
(71) Applicant: Nokia Corporation, 02150 Espoo (FI)
(72) Inventor: Asikainen, Kalle, 33960 Pirkkala (FI)
(74) Representative: Pursiainen, Timo Pekka

(57) **Abstract**

The invention relates to a synthesizer arrangement for generating signals simultaneously, the arrangement comprising as an input a frequency reference signal (F_{REF}) generated with stable crystal oscillator means (XO). The arrangement comprises first synthesizer means (115, 400) arranged to generate a first signal (F_{LO1}, F_{LO}) independently of the frequency reference signal (F_{REF}), and as their input a first control signal (116, F_{COR}) controlling the generation, on the basis of which the first signal is modified independently, and second synthesizer means (209, 400) arranged to generate a second signal (F_{LO1}, F_{LO}) independently of the frequency reference signal (F_{REF}), and as their input a second control signal (210, F_{COR}) controlling the generation, on the basis of which the second signal is modified independently. The first and the second synthesizer means (115, 209, 400) comprise a digital fractional-N frequency divider (403) for feedback, the frequency divider (403) being controlled with a bit word (404) which is arranged to be generated by means of a digital sigma-delta calculation circuit (405), whose input (F_{COR}) is one of said first and second control signals (116, 210), which is for example a frequency correction signal (116) or a frequency transfer signal (210).

## Description

The present invention relates to a synthesizer arrangement for generating two or more signals simultaneously as set forth in the preamble of the appended claim 1. The invention also relates to a transceiver system for a multimode radio telephone device as set forth in the preamble of the appended claim 8. The present invention also relates to a system for generating two or more signals as set forth in the preamble of the appended claim 13.

To allow mobility of persons, radio telephone devices of prior art are available. Such devices to be mentioned include a digital mobile station (MS) complying with the GSM (Global System for Mobile Communications) specifications and operating in a mobile communications network based on a cellular network (*e.g.* public land mobile network, PLMN). The PLMN network takes care of routing the communication and information via base transceiver stations (BTS) and mobile services switching centers (MSC). Other PLMN networks to be mentioned include also GSM-1800, GSM-1900, PDC, CDMA, US-TDMA, and IS-95.

The mobile station and the respective serving BTS must be synchronized for synchronization of various timings and controls of the transmission and reception of radio frequency (RF) signals, operations repeated at intervals, correction of the frequency standard, and settings of various counters both in the MS and in the BTS. It is known to use a signal transmitted by the BTS, for example on a broadcast control channel (BCCH) of the GSM system, with which the MS synchronizes itself and makes the necessary frequency correction (automatic frequency control, AFC). According to present regulations, the accuracy of the radio frequency (RF) used by the BTS can be even 0.05 ppm (parts per million) and stabile. The accuracy of the radio frequency used by the MS must be even 0.1-0.2 ppm compared with a signal received from the BTS.

As a result of the synchronization, sufficient accuracy and stability is also required particularly of the electronic circuits of the transceiver of the RF part of the MS, to minimize the need for repair and delays. In these circuits, it is known to use a voltage controlled crystal oscillator (VCXO) as the frequency reference, as it has the significant advantage of better accuracy and stability compared with other oscillator circuits of prior art. A disadvantage is that the crystal oscillator is normally a separate component which is even more than 100 to 10,000 times more expensive than the other circuit structrures and components and is placed separately in the circuit. To maintain the accuracy, the temperature must be controlled, wherein the oscillator crystal is normally placed within a separate encapsulation. It is known to use the crystal oscillator as a frequency reference for voltage controlled oscillators (VCO) which generate local oscillator (LO) signals. The LO signal is input for example in a mixer for the intermediate frequency (IF) part of the receiver, or in a mixer for the transmitter. By means of the mixers, the signal is mixed from baseband to radio frequency, or *vice versa.* The synchronization of the VCO with the frequency reference is based on a synthesizer, known as such. Synthesizers to be mentioned here include integer-N, fractional-N and sigma-delta fractional-N (SD FN).

There are also multimode radio telephone devices on the market, as systems combining a mobile phone and a GPS (Global Positioning System) satellite positioning device and having a common user interface (Ul). Also the GPS system requires accurate synchronization and stability, since the satellites transmit information about the position and time of transmission at carrier frequencies. The GPS system attempts to be tuned to these predetermined frequencies for reception, wherein for example the required frequency offset is calculated in relation to the frequency reference. On the basis of information obtained from several GPS satellites, the GPS device calculates its own position, rate and time. Normally, the systems have separate RF parts, such as a GSM transceiver and a GPS receiver, wherein they comprise their respective electronic circuits and particularly also separate crystal oscillators (VCXO) for synchronization, thereby significantly increasing the costs of the systems. For example due to the frequency differences, the first VCXO is AFC controlled (GSM) and the second VCXO is separately controlled (GPS) so that the systems could operate simultaneously, for example to implement an emergency call and positioning simultaneously. Due to the frequency differences of the signals, the common VCXO cannot be controlled.

It is a purpose of the present invention to achieve an improvement in the prior art to solve the above-presented problems. The synthesizer arrangement according to the invention is characterized in what will be presented in the characterizing part of claim 1. The transceiver system according to the invention is characterized in what will be presented in the characterizing part of claim 8. The method according to the invention is characterized in what will be presented in the characterizing part of claim 13.

The invention is based on a synthesizer arrangement, wherein multimode radio telephone devices use a single stable crystal oscillator (XO) to generate a signal which is now a preferably stable frequency reference and is used as an input for separate SD FN synthesizers. The synthesizers are used to generate the necessary LO signals for the respective transmitters and/or receivers of the systems in the device. Each system (*e.g.* GSM and GPS) controls, in turn, its own synthesizer circuit (for example offset or AFC control). The XO used does not need to be controlled, and the synthesizer circuit is a sigma-delta fractional-N (SD FN) synthesizer having lower frequency resolution and phase noise than other synthesizer circuits. The SD modulator of the synthesizer circuit has the known advantage that the frequency resolution of the circuit is independent of the frequency reference, and filtering of noise is easier with the loop filter of the circuit. An SD modulator is used to control the scaling of the frequency divider of the circuit. In the transmitters and receivers, the LO signals are input directly to the mixers, or they are still modified in a desired manner by another, simpler synthesizer circuit (integer-N) before inputting to the mixers.

In the following, the invention will be described in more detail by using as an example a preferred embodiment of the invention, particularly a 2-mode MS/GPS device, the MS preferably complying with the GSM specifications. It is obvious that the invention can also be applied in other multimode devices which comprise the required separate antennas and RF parts for reception and/or transmission and which particularly use LO signals for mixing, for example for IF frequencies, wherein at least transmitters and receivers based on the so-called superheterodyne principle are feasible. Examples to be mentioned here include a radio telephone device comprising two transceivers, for a mobile communications network and *e.g.* a satellite radio network; a transceiver for a mobile communications network and a receiver for a satellite positioning system; and a radio telephone device comprising two transceivers, for a mobile communications network and for example a short-range communications network. In the description, reference is made to the appended drawings, in which:
- Fig. 1: shows the operation of an MS/GPS device complying with a preferred embodiment of the invention in a block chart, and
- Fig. 2: is a block chart showing the operating principle of an SD FN synthesizer to be applied in the invention.

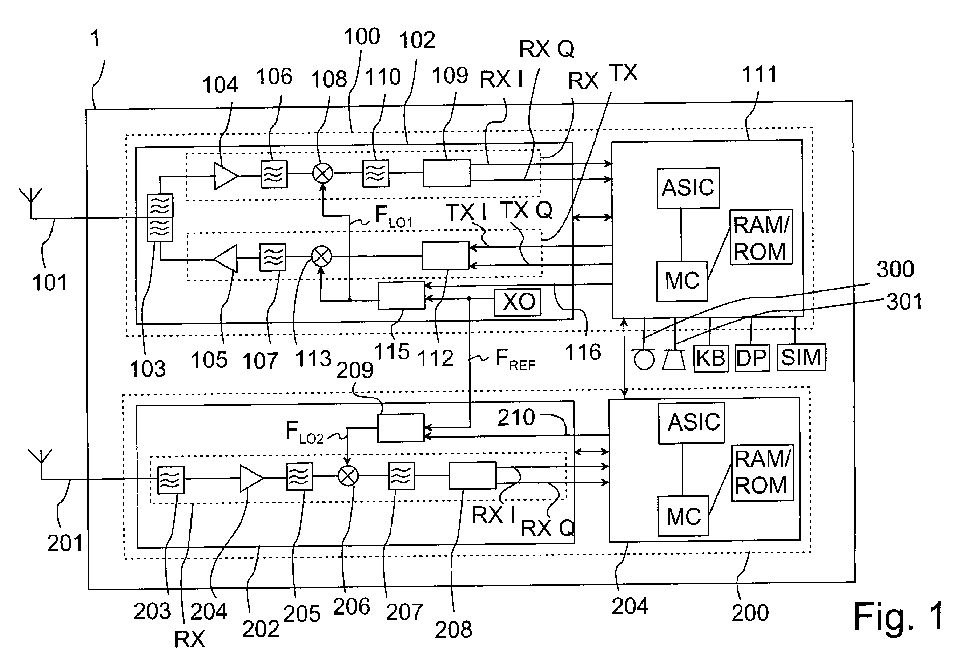

Figure 1 is a block chart showing an advantageous embodiment of an MS/GPS device 1 complying with the invention. It shows a 2-mode radio telephone device 1 including a GSM transceiver 100 and a GPS receiver 200. The GSM/GPS device 1 is intended to provide a combination of a mobile phone (which will be referred to with the term GSM below) operating in a public land mobile network (PLMN) based on a cellular network, and a satellite positioner (which will be referred to with the term GPS below). The device 1 comprises a GSM antenna 101 and a GPS antenna 201. Analog GSM RF parts 102 are provided for processing a received RF signal (receiver RX) and an RF signal to be transmitted (transmitter TX), comprising a duplex filter 103 in connection with an antenna 101, for filtering a desired frequency band. According to an advantageous embodiment, the transmitter TX and the receiver RX comprise amplifiers for amplifying the received signal (amplifier 104) and the signal to be transmitted (amplifier 105), auxiliary filters for filtering the amplified signal (filter 106) and the mixed signal (filter 107), and one or more mixers 108 for mixing the radio frequency of the received signal to an intermediate frequency for a demodulator 109. The mixer 108 is normally also followed by filtering 110. In the demodulator 109, the modulated signal is demodulated to baseband (BB) signals, in the GSM system to I/Q signals (RX I, RX Q) which are processed in a GSM digital signal processing (DSP) part 111 to determine the information contained in them. In a corresponding manner, the I/Q signals (TX I, TX Q) required for transmission (TX) are modulated in a modulator 112, after which the signal is mixed by a mixer 113 to transmission frequency (RF). After this, the signal is also filtered (filter 107) and amplified (amplifier 105) and input via a duplex filter 103 to the antenna 101. An LO signal (F_{LO1}) with a desired frequency is input in each filter 108, 113. For example, if the RX parts comprises several IF levels, also several filters are required, wherein also a variety of LO signals will be required. Thus, the F_{LO1} signal is, in turn, available as a frequency reference for a synthesizer (*e.g.* integer-N), known as such and having the final LO signal to be generated, if the signal properties are sufficient. Preferably another synthesizer is used, whose operation corresponds to that of the synthesizer 115. If necessary, LO signals with different frequencies are also input in the mixers 108 and 113, depending on the desired IF frequencies, to convert the signal frequency up or down. The GSM RX or GSM TX, as well as also the GPS RX, may also contain a synthesizer known as such (or also another SD FN synthesizer) which is used to process the LO signal further before it is input in the mixer 108 and/or 113 (or input in the mixer 206), to generate the desired, final LO signal. In this description, an LO signal, a VCO signal or a synthesized signal refers to an F_{LO1} and F_{LO2} signal which is input in an amplifier and/or a transmitter, wherein it is input directly in the mixer or in another synthesizer. The F_{LO1} and/or F_{LO2} signal are thus used as frequency references (that is, corresponding to the signal F_{REF}) for other synthesizers. It is obvious that the LO signal can also be utilized for other purposes. The operation and the more detailed structure of the duplex filter, the RF part and the DSP part are known as such and may also vary in a way obvious to anyone skilled in the art.

In prior art, LO signals (corresponding to the signal F_{LO1}) are generated with a synthesizer circuit whose frequency reference is a signal which is obtained directly from a crystal oscillator (VCXO) tuned by AFC control and with which the LO signal generated in the synthesizer is synchronized. The synchronization means the locking of the signal phase with the reference signal, that is the phase of the frequency reference signal. With phase locking, the frequency of the VCO of the synthesizer can be made stable and accurate. The stability of the crystal oscillator VCXO is based on a piezoelectric resonator, for example a quartz crystal. The relative accuracy of the frequency of the synthesizer is based on the accuracy of the frequency reference. The locking takes place in a known manner in a circuit comprising at least a phase locked loop (PLL) and a voltage controlled oscillator (VCO). The PLL, in turn, normally consists of a digital frequency divider, whose input is the frequency reference signal F_{REF}, followed by a phase detector and a PLL filter whose output is coupled to the VCO whose output, in turn, is the desired stable LO signal. The internal structure of the PLL may vary in a way known as such, and it may comprise for example mixers and frequency dividers to generate other signals. The output of the VCO is coupled as feedback to a phase detector whose output voltage is proportional to the phase difference of the LO and F_{REF} signals. The voltage signal, in turn, controls the phase of the VCO.

Conventionally, multimode devices comprise a separately controlled, independently tunable VCXO crystal for the GPS RF parts 202, but in the invention, the LO signals (F_{LO1}, F_{LO2}) are now generated in the GSM part 100 (transceiver 102 and part 111) and in the GPS part 200 (receiver 202 and part 204) separately with respective synthesizers (115, 209) which can be separately AFC or offset controlled or be set in a corresponding manner according to the respective need for control. The F_{REF} reference frequency used in common for the synthesizers, in turn, is a single stable XO crystal oscillator circuit which does not need to be controlled here. The XO circuit can be the crystal of the GPS part 200 or of the GSM part 100.

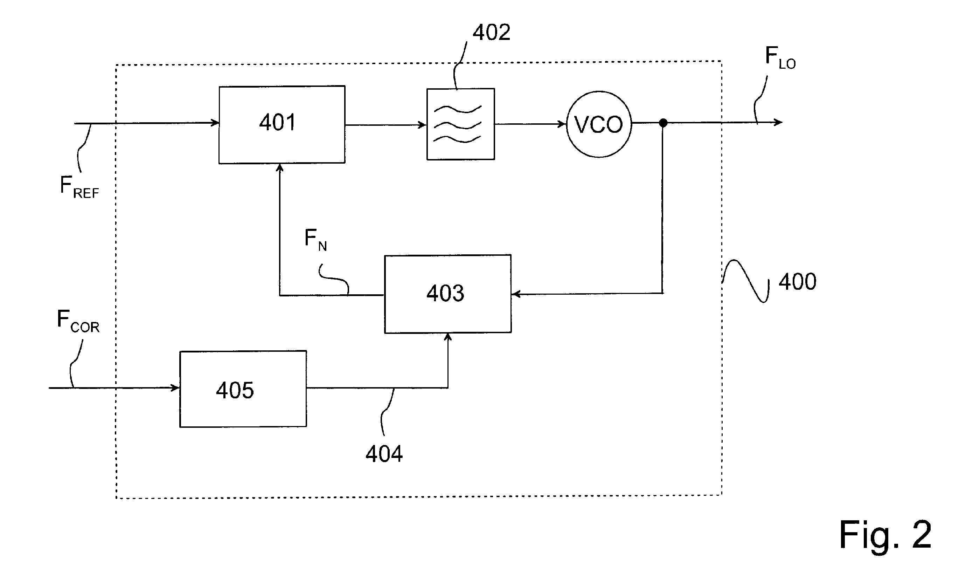

The invention makes it possible to use and control the GPS part 200 and the GSM part 100 simultaneously (to tune to the GSM receiving or transmission frequency and to GPS receiving simultaneously in the device 1), wherein for example the AFC control of the GSM part 100 does not interfere with or delay the GPS functions. It is now possible to use different frequencies for synchronization and tuning by using only one XO. The most significant advantage is to eliminate the need for two VCXO crystals. According to the invention, the synthesizer circuit of the GSM part 100 is the SD FN synthesizer 115 whose input is the XO signal F_{REF} and output is the LO signal F_{LO1} and which is shown in more detail in Fig. 2.

The digital processor means 111, *i.e.* the digital GSM DSP part 111, in turn, comprises systems, known as such, for processing the I/Q signal (in-phase/quadrature) and for presenting data by means of a user interface (Ul) to the user, applying a microphone 300, an earpiece or speaker 301, a keyboard KB, and a display DP installed in the device 1. The user interfaces vary from one device to another, comprising for example several displays or keypads, wherein also the appearance of the device may vary. The device 1 is also equipped with the necessary power sources, such as a replacable and rechargeable battery, for example for the operating voltage of the DSP and RF parts, and I/O connections. The power source and the user interface are normally at least partly common to the GPS and GSM parts (100, 200). The mobile phone is also provided with a SIM (subscriber identity module) card as well as a required quantity of memory (RAM/ROM) for storing information. In a known manner, the operation is controlled by a microcontroller (MC) unit with an application specific integrated circuit (ASIC). On the basis of the signal transmitted by the BTS, the GSM DSP part 111 also determines the required frequency correction (AFC) and controls, in turn, the SD FN synthesizer 115. The device 1 also comprises the required analog-to-digital (A/D) and digital-to analog (D/A) converters. The required correction is determined and the AFC correction signal is generated in a way obvious for anyone skilled in the art, according to the respective need.

The DSP part 111 is arranged to measure the frequency reference signal F_{LO1} and to calculate the required correction on the basis of the frequency difference between the BTS signal and the F_{LO1}. The required correction is input as a code 116 (AFC) with the desired form and extent in the frequency divider of the synthesizer 115. In a corresponding manner, the RX signal (I/Q signal) received in the GPS DSP part 204 is correlated with a reference signal to find out and lock the expected GPS RX signal for receiving information and processing the position data transmitted by the satellite. The DSP part 204 is arranged to correct (offset signal 210) the F_{LO2} signal of the synthesizer 209 for tuning to the expected medium frequency or for locking to an entirely new expected GPS transmission frequency. The search for the signal is implemented in a way known as such by searching and correlating, wherein also other factors can be taken into account in the correlation. The required control is input as a code 210 with the desired form and extent in the frequency divider of the synthesizer 209. In prior art, either the GPS VCXO or the GSM VCXO are controlled, but in the invention, the required correction (116, 210) to be determined by calculation is input as a code into the frequency divider of the synthesizer (115, 209), more precisely into the SD modulator of the SD FN synthesizer, which will be described in more detail in connection with Fig. 2.

The analog GPS RF parts 202 are arranged for processing the received radio frequency GPS signal (receiver RX), and the operation of the parts different from the invention is known as such and may also vary in a way obvious to anyone skilled in the art. For example, the receiver RX comprises a filter 203 connected with the antenna 201 for filtering a desired frequency band, an amplifier 204 for amplifying the received signal, a filter 205 for filtering the amplified signal, and one or more mixers 206 for down conversion (IF) of the frequency of the received signal for the demodulator 208. The mixer 206 is also followed by filtering 207. In the demodulator 208, the modulated signal is demodulated to baseband I/Q signals (RX I, RX Q) which are processed in the GPS DSP part 204. An LO signal with a desired frequency (F_{LO2}) is also input in the filter 206 and generated, according to the invention, by means of the synthesizer 209. If the receiver RX comprises several IF levels and mixers, also several synthesizers may be needed. In the invention, the F_{LO2} signal is generated with the separate, controlled synthesizer 209 and setting signal 210 of the GPS. The above-mentioned stable signal of the crystal oscillator (XO) is also used as the frequency reference F_{REF} for the synthesizer 209. As in the GSM part, the F_{LO2} can also be input in the new synthesizer, or it may have several SD FN synthesizers, wherein the receiver may also have synthesizers known as such *(e.g.* integer-N) for processing the LO signal from the F_{LO2} signal in a desired manner before it is input in the mixer 206.

The operation of the GPS DSP part 204 is controlled *e.g.* by a separate MC unit with the required ASIC circuit and RAM/ROM memory. The DSP part 204 is arranged to determine the required offset control of the F_{LO2} frequency and to control the synthesizer 209. It is obvious that, according to the device model, the functions of the DSP parts 111 and 204 are integrated or separated from each other in a way which is most suitable for the respective application or most preferable in view of the manufacturing technique. The integrated circuits are connected to each other to transfer signals and controls, *e.g.* by means of required buses, for mutual data transmission, coordination of functions, and synchronization. The details of the implementation will be obvious for anyone skilled in the art. The DSP parts 111 and 204, for example, apply the same keyboard KB and display DP, or the GPS part may have at least partly a separate Ul.

Figure 2 shows, in more detail, the SD FN synthesizer structure of the synthesizer means 400 which is applied in the synthesizers 115 and 209 of Fig. 1. The frequency reference F_{REF} is a stable, uncontrolled signal which is obtained from the XO crystal and input into a phase detector 401, possibly via a digital constant frequency divider. The output of the phase detector 401 is, in turn, input via a loop filter 402 into a voltage controlled oscillator (VCO) whose output signal is the desired F_{LO} reference frequency (thus corresponding to the signal F_{LO1} or F_{LO2} which may also be final LO signals). The F_{LO} is, in turn, coupled via a programmable digital FN frequency divider 403 (fractional-N) as feedback to the phase detector 401 (signal F_{N}). The phase comparison is made between the signals F_{REF} and F_{N}, and the signal F_{N} is different in the synthesizers 115 and 209. The output of the phase detector 401 controls the output of the VCO (signal F_{LO1,} F_{LO2}), and in a locking situation, which the circuit seeks thanks to the feedback, the desired F_{LO} is obtained. The more detailed internal operation of the synthesizer is known as such, and the divider is N and also its fractions (divider 403). The digital divider 403 is normally controlled with a bit word 404 which is obtained from a digital SD modulator circuit 405, whose more detailed operation is also known as such. On the basis of the AFC or offset corresponding control signal F_{COR} (which now corresponds to the signal 116 or 210 and which is preferably also a bit word) obtained from the DSP part (111 or 204), the SD circuit 405 generates the correct bit word 404 which controls the divider 403 in a desired manner, more precisely sets the divider N as desired. The F_{LO} frequency is generated in a programmable manner in steps which may, in the SD FN circuit, be smaller than the F_{REF}.

The invention has been described above as applied in connection with an advantageous embodiment, particularly an MS/GPS device. On the basis of the description, it will be obvious for anyone skilled in the art to apply the invention also in connection with other devices, of which examples have been given above, within the scope of the claims.

## Claims

1. A synthesizer arrangement for generating two or more signals simultaneously, the arrangement comprising as input a frequency reference signal (F_{REF}) generated with stable crystal oscillator means (XO), **characterized in that** the arrangement comprises
- first synthesizer means (115, 400) arranged to independently generate a first signal (F_{LO1}, F_{LO}) from the frequency reference signal (F_{REF}), as their output said first signal, and as their input a first control signal (116, F_{COR}) controlling the generation, on the basis of which the first signal is changed independently, and
- second synthesizer means (209, 400) arranged to independently generate a second signal (F_{LO1}, F_{LO}) from the frequency reference signal (F_{REF}), as their output said second signal, and as their input a second control signal (210, F_{COR}) controlling the generation, on the basis of which the second signal is changed independently.

2. The synthesizer arrangement according to claim 1, **characterized in that** the first and the second synthesizer means (115, 209, 400) comprise a digital fractional-N frequency divider (403) for feedback, the frequency divider (403) being controlled with a bit word (404) which is arranged to be generated by means of a digital sigma-delta calculation circuit (405), whose input (F_{COR}) is one of said first and second control signals (116, 210), which is for example a frequency correction signal (116) or a frequency transfer signal (210).

3. The synthesizer arrangement according to claim 1 or 2, **characterized in that** the first signal is coupled to a first RX receiver (GSM, RX) which is arranged for the reception of first RF signals, and that the second signal is coupled to a second RX receiver (GPS, RX) which is arranged for the reception of second RF signals.

4. The synthesizer arrangement according to claim 3, **characterized in that** the first signal is coupled to a first TX transmitter (GSM, TX) which is arranged for the transmission of third RF signals.

5. The synthesizer arrangement according to claim 3 or 4, **characterized in that** the first RX receiver and the second RX receiver are arranged in the same multimode radio telephone device (1) which also comprises a first antenna (101) coupled to the first RX receiver and a second antenna (201) coupled to the second RX receiver.

6. The synthesizer arrangement according to any of the claims 3 to 5, **characterized in that** the first RX receiver is arranged to receive first RF signals transmitted by a mobile communication network, the signals containing a synchronization signal, on the basis of which the first control signal (116, F_{COR}) is generated, and that the second RX receiver is arranged to receive second RF signals transmitted by a satellite system, on the basis of which the second control signal (210, F_{COR}) is generated for tuning of the RX receiver.

7. The synthesizer arrangement according to claim 6, **characterized in that** the first control signal (116, F_{COR}) contains a control code generated on the basis of the synchronization signal in first digital processing means (111) coupled to the first RX receiver, and that the second control signal (210, F_{COR}) contains a control code generated in the second digital processor means (204) coupled to the second RX receiver.

8. A transceiver system for a multimode radio telephone device comprising:
- a first part (100) comprising a first antenna (101) and first RF means (102) for receiving and/or transmitting signals, as well as first digital processing means (111) for processing said signals and generating a first control signal (116, F_{COR}),
- a second part (200) comprising a second antenna (201) and second RF means (202) for receiving and/or transmitting signals, as well as second digital processing means (111) for processing said signals and generating a second control signal (210, F_{COR}), and
- stable crystal oscillator means (XO) for generating a frequency reference signal (F_{REF}),
**characterized in that** for generating two or more signals simultaneously, the transceiver system also comprises:
- first synthesizer means (115, 400) arranged to independently generate a first signal (F_{LO1}, F_{LO}) from the frequency reference signal (F_{REF}), as their output said first signal, and as their input a first control signal (116, F_{COR}) controlling the generation, on the basis of which the first signal is independently modified, wherein the first signal is coupled to the first RF means (102), and
- second synthesizer means (209, 400) arranged to independently generate a second signal (F_{LO1}, F_{LO}) from the frequency reference signal (F_{REF}), as their output said second signal, and as their input a second control signal (210, F_{COR}) controlling the generation, on the basis of which the first signal is changed independently, wherein the second signal is coupled to the second RF means (202).

9. The transceiver system according to claim 8, **characterized in that** the first and the second synthesizer means (115, 209, 400) comprise a digital fractional-N frequency divider (403) for feedback, the frequency divider (403) being controlled with a bit word (404) which is arranged to be generated by means of a digital sigma-delta calculation circuit (405), whose input (F_{COR}) is one of said first and second control signals (116, 210).

10. The synthesizer arrangement according to claim 8 or 9, **characterized in that** the first RF means (102) comprise mixing means (108) whose input is the first signal (F_{LO1}) either as such or in a processed format, the first RF means (102) comprising third synthesizer means for processing the first signal, and that the second RF means (202) comprise mixing means (206) whose input is the second signal (F_{LO2}) either as such or in a processed format, the second RF means (202) comprising fourth synthesizer means for processing the second signal.

11. The transceiver system according to any of the claims 8 to 10, **characterized in that** the first part (100) is an MS part arranged to receive signals transmitted by a mobile communication network, wherein said signals comprise a synchronization signal for frequency correction, the synchronization signal being used as a basis for forming the first control signal (116, F_{COR}).

12. The transceiver system according to any of the claims 8 to 11, **characterized in that** the second part (200) is a GPS part arranged to receive signals transmitted by a satellite system, wherein said signals contain information for positioning of a radio telephone device, and wherein the second control signal (210, F_{COR}) is arranged to be formed on the basis of the received satellite signal.

13. A method for generating two or more signals, in which method
- stable crystal oscillator means (XO) are used to generate a frequency reference signal (F_{REF}),
**characterized in that** the method also comprises the steps of
- inputting said frequency reference signal in first synthesizer means (115, 400) for generating a first signal (F_{LO1}, F_{LO}) from the frequency reference signal (F_{REF}) in the output, and simultaneously inputting in them a first control signal (116, F_{COR}) for controlling the generation, on the basis of which the first signal is corrected independently, and
- inputting said frequency reference signal simultaneously also in second synthesizer means (209, 400) for generating a second signal (F_{LO1}, F_{LO}) from the frequency reference signal (F_{REF}) in the output, and simultaneously inputting in them a separate second control signal (210, F_{COR}) for controlling the generation, on the basis of which the second signal is corrected independently.

14. The method according to claim 13, **characterized in that** in the method:
- the first signal (F_{LO1}, F_{LO}) is coupled in first synthesizer means (115, 400) and the second signal (F_{LO2}, F_{LO}) in second synthesizer means (115, 400) as feedback via a digital fractional-N frequency divider (403) for comparison of the frequency reference signal (F_{REF}),
- said frequency divider (403) is controlled with a bit word (404), and
- said bit word (404) is generated by means of a digital sigma-delta calculation circuit (405), in which is input (F_{COR}) one of said first and second control signals (116, 210), which is for example a reference correction signal (116) or a frequency transfer signal (210).
